# EUROPEAN PATENT APPLICATION

(11) **EP 1 278 231 A2**
(43) Date of publication of application: **22.01.2003**
(21) Application number: 02254970.3
(22) Date of filing: 16.07.2002
(51) Int. Cl.: H01L 21/00

(54) **Substrate processing apparatus, substrate precessing method, and exposure apparatus**

(30) Priority: 17.07.2001 JP 2001216551
(71) Applicant: CANON KABUSHIKI KAISHA, Tokyo (JP)
(72) Inventor: Edo, Ryo, c/o Canon Kabushiki Kaisha, Tokyo (JP)
(74) Representative: Beresford, Keith Denis Lewis

(57) **Abstract**

A substrate processing apparatus of this invention includes a first chamber 1 which forms a predetermined environment such as a pressure-reduced atmosphere in its internal space, a second chamber 3 which communicates with an external environment through a first valve 4, and with the first chamber through a second valve 5, and a thermoregulator 11 which regulates the temperature of a substrate that is to be transferred to the second chamber. The substrate is supplied to the first chamber through the second chamber.

## Description

### FIELD OF THE INVENTION

The present invention relates to a substrate processing apparatus and substrate processing method and, for example, to a substrate processing apparatus and a substrate processing method suitable for a manufacturing process of a device such as a semiconductor device or liquid crystal display device.

### BACKGROUND OF THE INVENTION

Along with an increase in degree of integration of a semiconductor device, a semiconductor integrated circuit has been further micropatterned. For example, considering a semiconductor exposure apparatus which transfers a circuit pattern onto a silicon wafer, the wavelength of exposure light used in exposure must be shorten for micropatterning. The wavelength of the exposure light has been shortened from the g-line and i-line to a KrF laser beam, ArF laser beam, F₂ laser beam, and soft X-ray radiated from an SR ring, and to an electron beam, ion beam, or the like.

The exposure light with a short wavelength, such as the F₂ laser beam, soft X-ray, electron beam, and ion beam is greatly attenuated in the outer air. Thus, the exposure unit of an exposure apparatus is stored in a chamber. An N₂ atmosphere or reduced-pressure He atmosphere in which exposure light is less attenuated is formed in the chamber, and a vacuum atmosphere is formed for an electron beam exposure apparatus and the like.

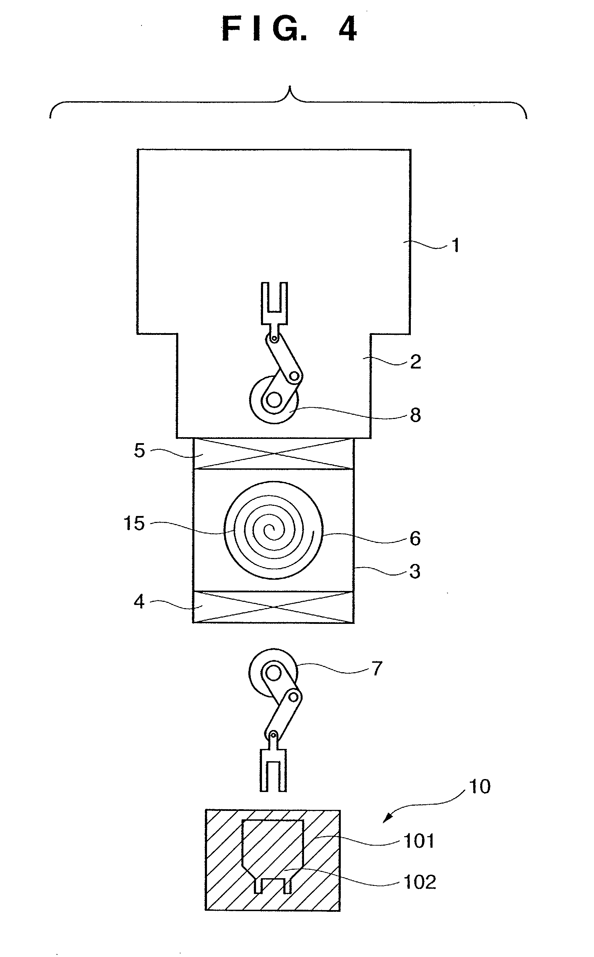

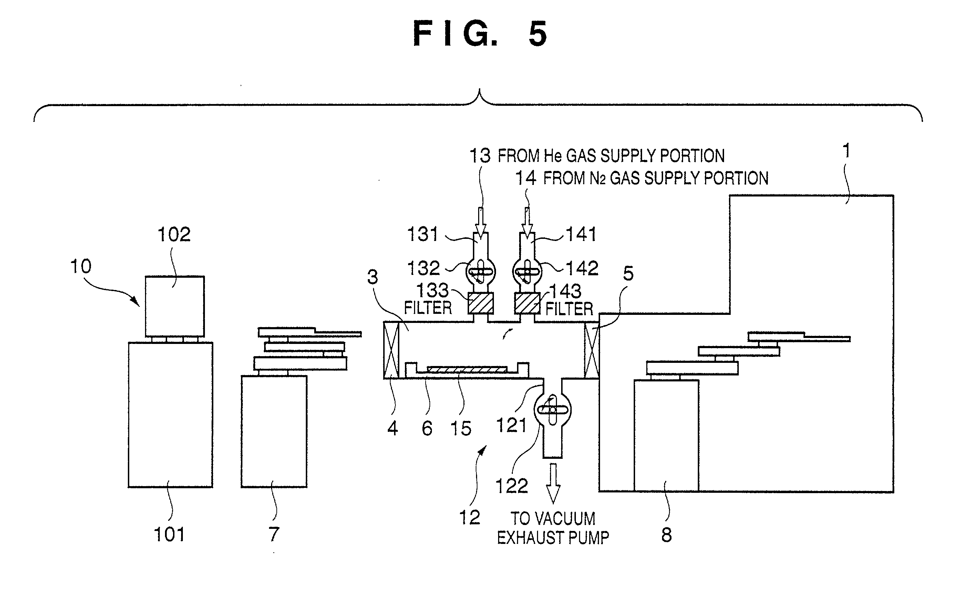

In a wafer processing apparatus or the like, when process gas is different from the outer air, or when oxidation of a resist is to be prevented, an atmosphere different from the outer air or the vacuum atmosphere is formed in a chamber 1. Conventionally, as this processing apparatus, an arrangement shown in Figs. 4 and 5 is known.

The wafer processing apparatus of this type includes the chamber 1 serving as a first process chamber which stores a process station for, e.g., exposing the wafer in the atmosphere different from the outer air, and a wafer supply portion 10 arranged in the outer air.

The wafer supply portion 10 includes a wafer carrier support portion 101, on which a carrier 102 storing the wafer is placed manually or by an automatic transfer apparatus. In order to transfer the wafer serving as a target substrate between the chamber 1 and the wafer supply portion 10, a load-lock chamber 3 serving as a second process chamber is arranged. A plurality of load-lock chambers 3 may be arranged for loading/unloading.

In the apparatus shown in Figs. 4 and 5, the reduced-pressure He atmosphere is formed in the chamber 1 which stores the processing unit.

The load-lock chamber 3 has a first gate valve 4 on the outer air side to shield the load-lock chamber 3 from the wafer supply portion 10 in the outer air, and a second gate valve 5 on the chamber side to shield the load-lock chamber 3 from the chamber 1. The load-lock chamber 3 also has an exhaust mechanism 12 for exhausting gas from the load-lock chamber 3, an He gas supply portion 13 for supplying He gas into the load-lock chamber 3, and an N₂ gas supply portion 14 for supplying N₂ gas into the load-lock chamber 3.

The load-lock chamber 3 includes a wafer table 6 to receive, e.g., one or a plurality of wafers.

In the outer air, a first transfer mechanism 7 for transferring the wafer between the carrier 102 on the carrier support portion 101 and the load-lock chamber 3 is arranged. In a preliminary chamber 2 connected between the chamber 1 and the load-lock chamber 3, a second transfer mechanism 8 for transferring the wafer between the load-lock chamber 3 and the process station is arranged.

The operation of the conventional apparatus will be described below. The first transfer mechanism 7 extracts one wafer from the wafer carrier 102 placed on the wafer carrier support portion 101, and transfers the wafer to the load-lock chamber 3.

When the wafer is loaded into the load-lock chamber 3 and placed on the wafer table 6, the first gate valve is closed to shield the load-lock chamber 3 from the outer air. The atmosphere in the load-lock chamber 3 is purged.

Purging the atmosphere in the load-lock chamber 3 is performed to be described below. A vacuum exhaust valve 122 is opened in a state wherein the load-lock chamber 3 is shielded from the outer air and the chamber 1 by closing the first and second gate valves 4 and 5. The gas is then exhausted from the load-lock chamber 3 by a vacuum exhaust pump (not shown) via a vacuum exhaust pipe 121. The chamber is evacuated till a predetermined vacuum degree. After evacuating the chamber to the predetermined vacuum degree, the vacuum exhaust valve 122 is closed, and the evacuation is stopped.

The gas supply valve is then opened. The load-lock chamber 3 shown in Figs. 4 and 5 includes an He gas supply valve and N₂ gas supply valve. At this stage, an He gas supply valve 132 of these valves is opened to supply the same gas as the atmosphere in the chamber 1 storing the process station.

Until the pressure in the load-lock chamber 3 equals that in the process chamber 1, the He gas is supplied. When the pressure in the load-lock chamber 3 equals that in the process chamber 1, the He gas supply valve 132 is closed to stop supplying the He gas.

When supply of the He gas is stopped, the second gate valve 5 is opened. The wafer on the wafer table 6 is extracted by the second transfer mechanism 8 in the preliminary chamber 2, and transferred to the process station (not shown) in the chamber 1.

The wafer processed in the process station is returned to the wafer carrier 102 via the load-lock chamber 3 by the first and second transfer mechanisms 7 and 8.

During evacuation of the load-lock chamber 3 in the above apparatus, adiabatic expansion occurs in the load-lock chamber 3, and the gas in the load-lock chamber 3 is cooled. At this time, since the wafer in the load-lock chamber 3 is exposed to the gas in the load-lock chamber 3, the wafer temperature is reduced along with cooling the gas. The wafer cooled by the adiabatic expansion in the load-lock chamber 3 is loaded into the chamber 1, and processed at the end of purging the atmosphere.

In the exposure apparatus, the wafer temperature needs to be controlled with high precision in order to obtain high transfer precision, the high line-width precision, and the like. However, in the conventional apparatus, the temperature of the wafer loaded into the chamber 1 via the load-lock chamber 3 is reduced as described above. Hence, the transfer precision deteriorates when exposure is performed for the wafer in this state, thus posing a problem.

As a prior art related to the problem as described above, an example is available, in which in order to control the wafer to a predetermined temperature, the wafer is brought into contact with ambient gas and a wafer transfer mechanism to gradually increase the wafer temperature to the predetermined temperature.

In another example of the prior art, a heating means such as a heater is arranged in a load-lock chamber to heat the wafer, thereby preventing the reduction of the wafer temperature by the adiabatic expansion. Such an apparatus arrangement is shown in USP5,914,493. In this example, a wafer heating means 15 is arranged on the wafer table 6 in the load-lock chamber 3. The wafer heating means 15 is a heater. As another example of the heating means, a heating method is available, in which a wafer is irradiated with light from a lamp to heat the wafer, as disclosed in Japanese Patent Laid-Open Nos. 10-284389 and 2000-058455.

The former method is simple in the apparatus arrangement, but requires a long period of time for which the wafer reaches the predetermined temperature. This makes it difficult to improve the throughput. Specifically, in the apparatus in which the chamber is evacuated, since heat exchange is not performed with the ambient gas, thermoregulation by the ambient gas is not expected. Hence, in this case, the wafer is thermally regulated by only contact with the wafer transfer mechanism. This requires a longer period of time for which the wafer reaches the predetermined temperature.

According to the latter method, the structure of the load-lock chamber is complicated, the heating means in the load-lock chamber is difficult to maintain, and heat generated by the heating means is transferred to the load-lock chamber so that the load-lock chamber deforms, thereby decreasing the precision of the wafer transfer.

### SUMMARY OF THE INVENTION

The present invention has been made in consideration of the above situation, and has as its object to provide a substrate processing apparatus, a method therefor, and the like which can prevent a disadvantage, e.g., low throughput, caused by, e.g., reduction of a substrate temperature along with a decrease in pressure in a load-lock chamber.

The first aspect of the present invention relates to a substrate processing apparatus. The apparatus comprises a first chamber, a second chamber which has first and second valves, and communicates with the first chamber via the second valve, and a thermoregulator which regulates a substrate temperature. The substrate is then transferred to the second chamber via the first valve, and transferred from the second chamber to the first chamber via the second valve. The thermoregulator is arranged to regulate the temperature of the substrate to be transferred to the second chamber through the first valve before transferring the substrate to the second chamber.

According to a preferred embodiment of the present invention, the thermoregulator is arranged to heat the substrate.

According to another preferred embodiment of the present invention, the apparatus can further comprise a pressure reduction mechanism which reduces a pressure in the second chamber before transferring the substrate from the second chamber to the first chamber after transferring the substrate to the second chamber. The apparatus can further comprises a gas supply mechanism which supplies predetermined gas into the second chamber to match an environment in the second chamber to an environment in the first chamber before transferring the substrate from the second chamber to the first chamber after the pressure reduction mechanism reduces the pressure in the second chamber.

According to still another preferred embodiment of the present invention, the substrate temperature in the second chamber is reduced with a decrease in pressure in the second chamber, and thermoregulation of the substrate by the thermoregulator is preferably determined in consideration of the reduction of the substrate temperature in the second chamber so as to transfer the substrate with a predetermined temperature from the second chamber to the first chamber.

According to still another preferred embodiment of the present invention, thermoregulation of the substrate by the thermoregulator is carried in consideration of the reduction of the substrate temperature in said second chamber and change in the substrate temperature during period from transferring the substrate to the first chamber until processing the substrate.

According to still another preferred embodiment of the present invention, the thermoregulator can be arranged, e.g., to regulate the substrate temperature in a state wherein the substrate is held by a substrate transfer mechanism for transferring the substrate to the second chamber.

According to still another preferred embodiment of the present invention, the thermoregulator can be arranged, e.g., to regulate the substrate temperature by supplying gas to the substrate. The thermoregulator preferably has a removing portion, e.g., a filter for removing particles from gas to be supplied to the substrate.

According to still another preferred embodiment of the present invention, the apparatus preferably further comprises a temperature measuring device which measures the substrate temperature regulated by the thermoregulator to supply the measurement result to the thermoregulator.

According to still another preferred embodiment of the present invention, for example, an exposure process portion for transferring a pattern onto the substrate can be arranged in the first chamber.

According to still another preferred embodiment of the present invention, for example, the atmosphere in the first chamber can be maintained to a reduced pressure.

The second aspect of the present invention relates to a substrate processing method. The method comprises the steps of heating a substrate exposed to an external environment, supplying the heated substrate to a load-lock chamber, reducing a pressure in the load-lock chamber, supplying the substrate from the load-lock chamber to a process chamber, and processing the substrate in the process chamber.

According to a preferred embodiment of the present invention, for example, the method further comprises the step of supplying predetermined gas into the load-lock chamber to match an environment in the load-lock chamber to an environment in the process chamber before transferring the substrate from the load-lock chamber to the process chamber after reducing the pressure in the load-lock chamber.

The third aspect of the present invention relates to a device manufacturing method. The method comprises the steps of installing, in a device manufacturing factory, manufacturing apparatuses for various processes including the above substrate processing apparatus and manufacturing a device by a plurality of processes using the manufacturing apparatuses.

According to a preferred embodiment of the present invention, the method preferably further comprises the steps of connecting the manufacturing apparatuses via a local area network, and communicating information about at least one of the manufacturing apparatuses between the local area network and an external network outside the device manufacturing factory.

According to another preferred embodiment of the present invention, the method further comprises the step of accessing a database provided by a vendor or user of the substrate processing apparatus via the external network, thereby obtaining maintenance information of the exposure apparatus by data communication.

According to still another preferred embodiment of the present invention, the method preferably further comprises the step of performing data communication between the device manufacturing factory and another device manufacturing factory via the external network, thereby performing production management.

The fourth aspect of the present invention relates to a device manufacturing factory. The device manufacturing factory comprises manufacturing apparatuses for various processes including the above substrate processing apparatus, a local area network for connecting the manufacturing apparatuses, and a gateway for allowing access to an external network outside the factory from the local area network, wherein information about at least one of the manufacturing apparatuses can be communicated between the local area network and the external network.

The fifth aspect of the present invention relates to a maintenance method of the above substrate processing apparatus installed in the device manufacturing factory. The method comprises the steps of making a vendor or user of the substrate processing apparatus provide a maintenance database connected to an external network outside the device manufacturing factory, allowing access to the maintenance database from the device manufacturing factory via the external network, and transmitting maintenance information accumulated in the maintenance database to the device manufacturing factory via the external network.

According to a preferred embodiment of the present invention, the above substrate processing apparatus preferably further comprises a display, a network interface, and a computer for executing network software, and the display, the network interface, and the computer enable communicating maintenance information of the substrate processing apparatus via a computer network. The network software preferably provides on the display the user interface for accessing a maintenance database provided by a vendor or user of the exposure apparatus and connected to the external network outside a factory in which the substrate processing apparatus is installed, and information is obtained from the database via the external network.

According to another preferred embodiment of the present invention, a thermoregulator for regulating the temperature of a substrate before loading the substrate into a load-lock chamber is arranged. A decrease in temperature of the substrate cooled in the load-lock chamber is taken into consideration in advance, and the substrate is heated to a temperature higher by the decrease before loading the substrate into the load-lock chamber. The substrate is then loaded into the process chamber of the apparatus through the load-lock chamber.

In the above operation, the temperature of the substrate loaded into the process chamber is the predetermined temperature when loaded into the chamber. Hence, the subsequent processes such as exposure can immediately be performed for the substrate, thereby improving the throughput.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a plane view showing an example of an apparatus arrangement according to a preferred embodiment of the present invention;
Fig. 2 is a side view showing the example of the apparatus arrangement according to the preferred embodiment of the present invention;
Fig. 3 is a view for explaining one example of a wafer thermoregulator according to the preferred embodiment of the present invention;
Fig. 4 is a plane view for explaining a conventional apparatus arrangement;
Fig. 5 is an elevation for explaining the conventional apparatus arrangement;
Fig. 6 is a view showing one example of an exposure apparatus according to the preferred embodiment of the present invention;
Fig. 7 is a conceptual view of a semiconductor device production system using the exposure apparatus according to the present invention when viewed from a given angle;
Fig. 8 is a conceptual view of a semiconductor device production system using the exposure apparatus according to the present invention when viewed from another angle;
Fig. 9 is a concrete example of a user interface;
Fig. 10 is a view for explaining the flow of a device production process; and
Fig. 11 is a view for explaining a wafer process.

### DETAILED DESCRIPTION OF THE PREFERRED EMBODIMENTS

### (Embodiment of Substrate Processing Apparatus and Substrate Transfer Method)

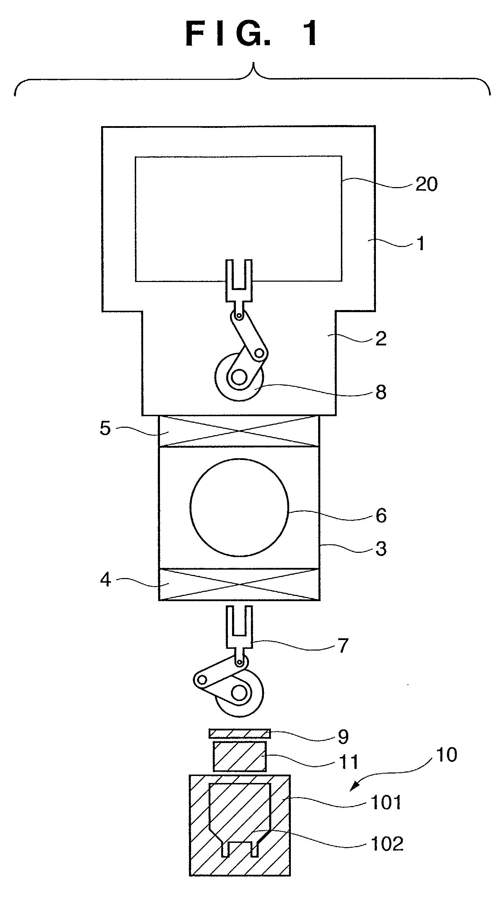

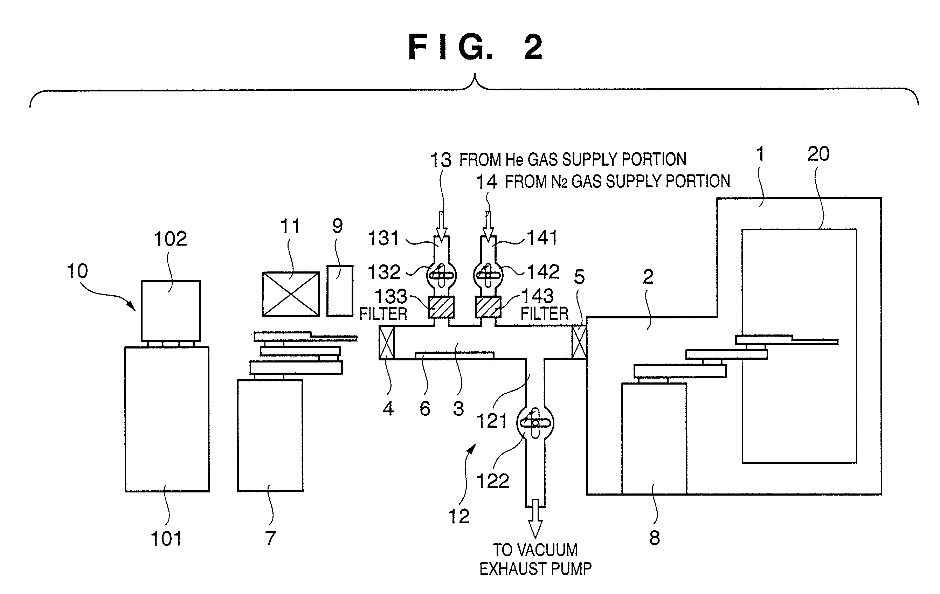

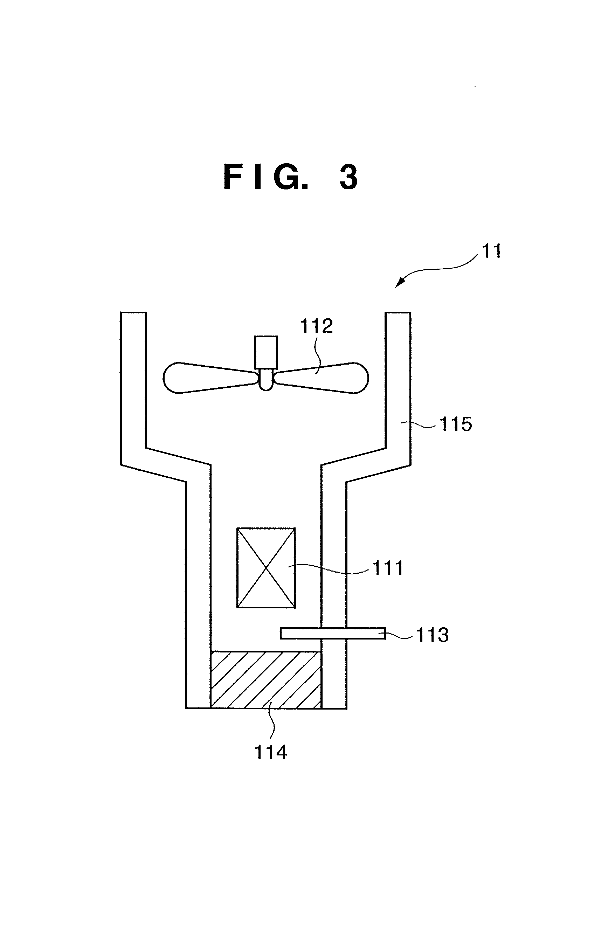

Fig. 1 is a plan view showing an apparatus arrangement of a substrate processing apparatus according to a preferred embodiment of the present invention. Fig. 2 is an elevation of the apparatus. Fig. 3 is a view for explaining one example of a wafer thermoregulator of the apparatus shown in Figs. 1 and 2.

The substrate processing apparatus according to the embodiment comprises a process chamber 1 serving as the first chamber and a wafer supply portion 10 arranged in the outer air. The process chamber 1 is arranged as a part of an exposure apparatus. The process chamber 1 has an internal space in which an exposure process portion 20 for transferring a pattern to a wafer is arranged and a pressure-reduced He atmosphere is maintained.

The wafer supply portion 10 has a wafer carrier support portion 101, on which a wafer carrier 102 storing the wafer is placed manually or by an automatic transfer apparatus. A preliminary chamber 2 which contains a second transfer mechanism 8 is connected to the first chamber 1.

In order to exchange the wafer between the different atmospheres, a load-lock chamber 3 serving as the second chamber is arranged between the chamber 1 and the wafer supply portion 10. The load-lock chamber 3 includes a first gate valve 4 on the outer air side to shield the load-lock chamber 3 from the wafer supply portion 10 in the outer air (external environment), and a second gate valve 5 on the chamber side to shield the load-lock chamber 3 from the preliminary chamber 2.

The load-lock chamber 3 also includes an exhaust mechanism 12 for exhausting gas from the load-lock chamber 3, an He gas supply portion 13 for supplying He gas into the load-lock chamber 3, and an N₂ gas supply portion 14 for supplying N₂ gas into the load-lock chamber 3.

The load-lock chamber 3 has a wafer table 6 designed, e.g., to store one or a plurality of wafers.

The load-lock chamber 3 and the second transfer mechanism 8 are arranged to transfer the wafers one by one. The internal volume of the load-lock chamber 3 is set to a minimum size to minimize an exhaustion time. A device for heating the wafer must be arranged upstream of the load-lock chamber 3 to achieve such downsizing.

A first transfer mechanism 7 for transferring the wafer between the wafer carrier 102 on the wafer carrier support portion 101 and the load-lock chamber 3 is arranged in the outer air. The second transfer mechanism 8 for transferring the wafer between the load-lock chamber 3 and a process station (exposure process portion) 20 is arranged in the preliminary chamber 2 connected between the chamber 1 and the load-lock chamber 3.

A wafer thermoregulator 11 is arranged midway along a path where the first transfer mechanism 7 transfers the wafer. One example of the wafer thermoregulator is shown in Fig. 3. The wafer thermoregulator 11 shown in Fig. 3 is arranged as follows. A housing 115 accommodates a heater 111 for generating high-temperature heat, a fan 112 for supplying air through the heater 111, and a filter 114 serving as a particle removing device at the front end of the fan 112. A temperature measuring device 113 for measuring the heated air temperature is attached to the housing 115.

The operation of the wafer transfer in the exposure apparatus according to the present invention will be described next. The arm of the first transfer mechanism 7 is inserted into the wafer carrier 102 in the outer air, and one wafer is chucked by this arm. By bending the arm which chucks the wafer, the wafer is extracted from the wafer carrier 102. After that, a sensor (not shown) checks the state of the atmosphere in the load-lock chamber 3.

In this case, assume that the load-lock chamber 3 is set in the atmospheric state. The transfer mechanism 7 rotates the arm toward the load-lock chamber 3, stretches the arm after confirming that the gate valve 4 is open, and then loads the wafer into the load-lock chamber 3 to place the wafer on the wafer table 6.

In the path where the transfer mechanism 7 transfers the wafer from the wafer carrier 102 into the load-lock chamber 3, the wafer thermoregulator 11 heats the wafer by blowing the heated gas such as air to the wafer.

The heating temperature of the wafer is determined in consideration of the reduction of the wafer temperature caused by an adiabatic expansion along with a vacuum suction in the load-lock chamber 3. That is, the heating temperature (target temperature) of the wafer is determined in consideration of the decrease in temperature so as to heat the wafer cooled by the adiabatic expansion to the predetermined temperature. The decrease in wafer temperature can be theoretically calculated by the volume, pressure before the vacuum suction, and ambient temperature in the load-lock chamber 3, the vacuum pressure obtained by the vacuum suction operation, a time required for the vacuum suction, and the heat exchange ratio of the gas and wafer in the load-lock chamber 3.

The decrease in wafer temperature caused by the adiabatic expansion is calculated in advance. A heating time is calculated on the basis of the temperature of heated air and the heat exchange ratio of the outer air and wafer. The heated air may be blew to the wafer for the calculated time.

The heating time of the wafer by the wafer thermoregulator 11 may be determined by heating time data input manually or by an external apparatus, or may be calculated by an arithmetic unit or control unit arranged inside or outside the exposure apparatus in accordance with the above calculation condition input manually or by the external apparatus. Alternatively, the heating time of the wafer may be calculated on the basis of various data stored in the calculation unit or control unit, which are obtained when the immediately preceding wafer is loaded into the load-lock chamber 3.

The temperature of the heated air may be obtained by measuring the temperature of the heated air at the outlet of the wafer thermoregulator 11, or by using a theoretical value. The temperature of the heated air blew from the wafer thermoregulator 11 is preferably controlled to a constant value. This makes it easy to calculate and control the heating time. In addition, variations in heating effect (the temperature after heating) of the plurality of wafers can be reduced.

The thermoregulator may be arranged in a way different from the examples shown in Figs. 1 to 3. The station may be arranged in front of the load-lock chamber, and an electric heater, electromagnetic heater, or the like may be arranged in the station. The temperature of the wafer placed in the station may be thermally regulated by the heater. Alternatively, a device for irradiating a wafer with light from an infrared lamp or the like to heat the wafer may be arranged as the thermoregulator.

In the exposure apparatus of this embodiment, a wafer temperature measuring device 9 for measuring the temperature of the heated wafer in a noncontact manner is preferably arranged. The wafer temperature measuring device 9 measures the wafer temperature during heating. Heating is controlled by the thermoregulator 11 on the basis of the calculation result, thereby more accurately controlling the wafer temperature.

At this stage, it is preferable that the noncontact temperature measuring device 9 be used to minimize the contamination and the like of the wafer, and to sense the temperature of the wafer surface. However, a contact temperature measuring device may be used. For example, a contact temperature measuring device can be arranged in the arm or the like of the first transfer mechanism 7, which is brought into contact with the wafer. In this case, the temperature can be controlled with high precision as well.

After setting the heated wafer in the load-lock chamber 3, the transfer mechanism 7 moves the arm backward to refract the arm from the load-lock chamber 3. After that, the gate valve 4 is closed, and the vacuum exhaust valve 122 is opened to exhaust the air from the load-lock chamber 3 till the predetermined vacuum degree. When exhausting, the temperature of the atmosphere in the load-lock chamber 3 is reduced by adiabatic expansion, and the wafer coming into contact with this atmosphere is cooled.

When the atmosphere in the load-lock chamber 3 have been completely exhausted (when the vacuum exhaust valve 122 is closed), an He gas supply source 132 is opened to supply He gas into the load-lock chamber 3 in order to make the atmosphere in the load-lock chamber 3 equivalent to that in the chamber 1 and preliminary chamber 2. When the atmosphere in the load-lock chamber 3 become the pressure-reduced He atmosphere with the pressure substantially equal to that in the chamber 1 and the preliminary chamber 2, the gate valve 5 is opened, and the arm of the second transfer mechanism 8 is inserted into the load-lock chamber 3.

The wafer has been transferred to the process station (in this case, the exposure process portion) 20 by the second transfer mechanism 8. At this stage, the wafer temperature is reduced to reach the predetermined temperature. Hence, the predetermined wafer process (in this case, exposure) can be immediately performed in this state.

In the substrate processing apparatus described above, the substrate is processed in the pressure-reduced He atmosphere in the chamber 1. However, in another application, the substrate may be processed in the pressure-reduced atmosphere (pressure-reduced environment) of gas other than He gas in the chamber 1. Furthermore, in still another application, the substrate may be processed in an atmosphere with predetermined pressure such as atmospheric pressure in the chamber 1. Furthermore, the substrate may be processed in so-called vacuum environment whose pressure is less than several Pa such as 10⁻¹² to several Pa. That is, the present invention can apply to all apparatuses in which the substrate in the atmospheric environment is exposed to the pressure-reduced atmosphere (for example, the pressure-reduced atmosphere is once formed in order to purge the atmosphere).

### (Embodiment of Exposure Apparatus)

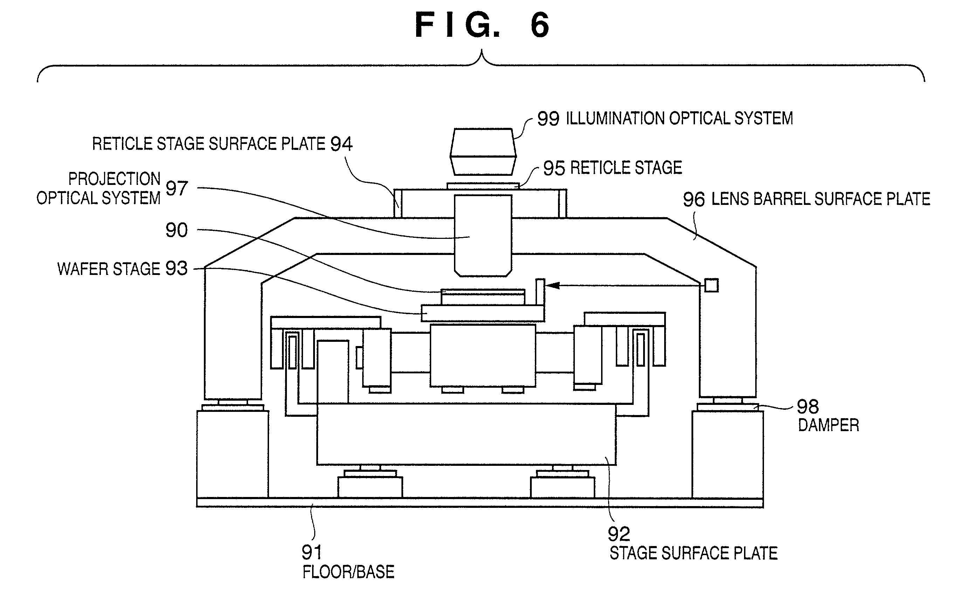

An exposure apparatus (exposure process portion) 20 according to an embodiment of the present invention will be described by exemplifying a scanning exposure apparatus. Fig. 6 is a front view showing an example of the main structure of the scanning exposure apparatus according to the preferred embodiment of the present invention. This exposure apparatus, or a part of which including a wafer stage is arranged in the above first process chamber, and performs exposure for the substrate (wafer).

In Fig. 6, a lens barrel surface plate 96 is supported by a floor/base 91 via a damper 98. The lens barrel surface plate 96 supports a reticle stage surface plate 94, and also supports a projection optical system 97 arranged between a reticle stage 95 and a wafer stage 93.

The wafer stage 93 having a chuck 90 is supported on a stage surface plate 92 arranged on the floor/base 91, and holds the wafer set on the chuck 90 to position the wafer. The reticle stage 95 is supported on the reticle stage surface plate 94 supported by the lens barrel surface plate 96, and can move while mounting the reticle serving as a master on which a circuit pattern is formed. Exposure light for exposing the reticle mounted on the reticle stage 95 onto the wafer on the wafer stage 93 is emitted from an illumination optical system 99.

The wafer stage 93 is scanned in synchronism with the reticle stage 95. During scanning of the reticle stage 95 and the wafer stage 93, the positions of both stages are continuously detected by interferometers, respectively, and the detection results are fed back to driving units of the reticle stage 95 and wafer stage 93. Hence, the scanning start positions of both the stages can be accurately synchronized, and the scanning speed in a constant-speed scanning region can be controlled with high precision. While both the stages scan the projection optical system 97, the reticle pattern is exposed on the wafer, and the circuit pattern is transferred.

### (Embodiment of Semiconductor Production System)

A production system for a semiconductor device (semiconductor chip such as an IC or LSI, a liquid crystal panel, a CCD, a thin-film magnetic head, a micromachine, or the like) using an exposure apparatus according to the present invention will be exemplified. The system performs maintenance services such as trouble shooting, periodic maintenance, and software distribution for manufacturing apparatuses installed in a semiconductor manufacturing factory by utilizing a computer network or the like outside the manufacturing factory.

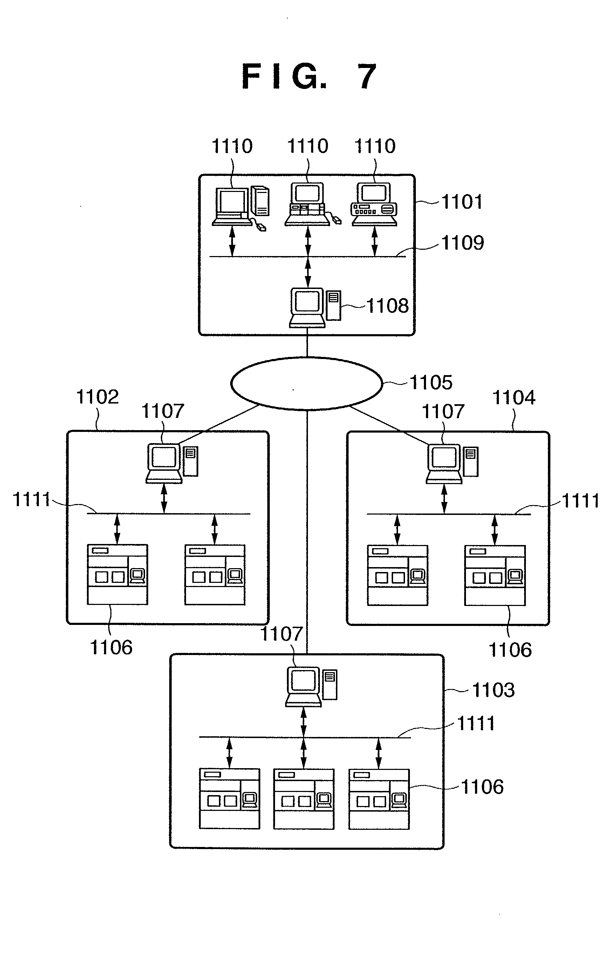

Fig. 7 shows the overall system cut out at a given angle. In Fig. 7, reference numeral 1101 denotes an office of a vendor (apparatus supply manufacturer) which provides a semiconductor device manufacturing apparatus. Examples of the manufacturing apparatus are semiconductor manufacturing apparatuses for various processes used in a semiconductor manufacturing factory, such as pre-process apparatuses (lithography apparatus including an exposure apparatus, resist processing apparatus, and etching apparatus, an annealing apparatus, a film formation apparatus, a planarization apparatus, and the like) and post-process apparatuses (assembly apparatus, inspection apparatus, and the like). The office 1101 comprises a host management system 1108 which provides a maintenance database for the manufacturing apparatus, a plurality of operation terminal computers 1110, and a LAN (Local Area Network) 1109 which connects the host management system 1108 and computers 1110 to build an intranet or the like. The host management system 1108 has a gateway for connecting the LAN 1109 to Internet 1105 serving as an external network of the office, and a security function for limiting external accesses.

Reference numerals 1102 to 1104 denote manufacturing factories of the semiconductor manufacturer as users of manufacturing apparatuses. The manufacturing factories 1102 to 1104 may belong to different manufacturers or the same manufacturer (pre-process factory, post-process factory, and the like). Each of the factories 1102 to 1104 is equipped with a plurality of manufacturing apparatuses 1106, a LAN (Local Area Network) 1111 which connects these apparatuses 1106 to construct an intranet, and a host management system 1107 serving as a monitoring apparatus which monitors the operation status of each manufacturing apparatus 1106. The host management system 1107 in each of the factories 1102 to 1104 has a gateway for connecting the LAN 1111 in the factory to the Internet 1105 serving as an external network of the factory. Each factory can access the host management system 1108 of the office 1101 of vendor from the LAN 1111 via the Internet 1105. The security function of the host management system 1108 authorizes access of only a limited user. More specifically, the factory can notify the vendor via the Internet 1105 of status information (e.g., the symptom of a manufacturing apparatus in trouble) representing the operation status of each manufacturing apparatus 1106. Also, the factory can receive, from the vendor, response information (e.g., information designating a remedy against the trouble, or remedy software or data) corresponding to the notification, or maintenance information such as the latest software or help information. Data communication between the factories 1102 to 1104 and the office 1101 of the vendor and data communication via the LAN 1111 in each factory adopt a communication protocol (TCP/IP) generally used in the Internet. Instead of using the Internet as an external network of the factory, a high-security dedicated network (e.g., ISDN) which inhibits access of a third party can be adopted. The host management system is not limited to the one provided by the vendor. The user may construct a database and set the database on an external network, and the host management system may authorize access to the database from a plurality of user factories.

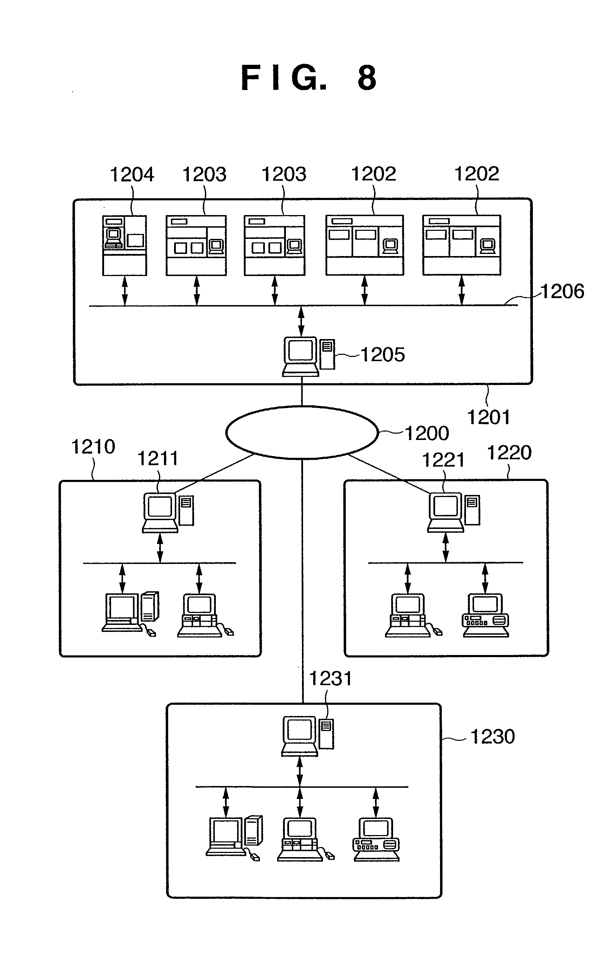

Fig. 8 is a view showing the concept of the overall system of this embodiment that is cut out at a different angle from Fig. 7. In the above example, a plurality of user factories having manufacturing apparatuses and the management system of the manufacturing apparatus vendor are connected via an external network, and production management of each factory or information about at least one manufacturing apparatus is communicated via the external network. In the example of Fig. 8, a factory having manufacturing apparatuses provided by a plurality of vendors and the management systems of the vendors for these manufacturing apparatuses are connected via the external network of the factory, and maintenance information of each manufacturing apparatus is communicated. In Fig. 8, reference numeral 1201 denotes a manufacturing factory of a manufacturing apparatus user (semiconductor device manufacturer). Manufacturing apparatuses for various processes, e.g., an exposure apparatus 1202, resist processing apparatus 1203, and film formation apparatus 1204 are installed in the manufacturing line of the factory. Fig. 8 shows only one manufacturing factory 1201, but a plurality of factories are networked in practice. The respective apparatuses in the factory are connected to each other by a LAN 1206 to build an intranet, and a host management system 1205 manages the operation of the manufacturing line.

The offices of vendors (apparatus supply manufacturers) such as an exposure apparatus manufacturer 1210, resist processing apparatus manufacturer 1220, and film formation apparatus manufacturer 1230 comprise host management systems 1211, 1221, and 1231 for executing remote maintenance for the supplied apparatuses. Each host management system has a maintenance database and a gateway for an external network, as described above. The host management system 1205 for managing the apparatuses in the manufacturing factory of the user, and the management systems 1211, 1221, and 1231 of the vendors for the respective apparatuses are connected via the Internet or dedicated network serving as an external network 1200. In this system, if a trouble occurs in any one of the manufacturing apparatuses along the manufacturing line, the operation of the manufacturing line stops. This trouble can be quickly solved by remote maintenance from the vendor of the apparatus in trouble via the Internet 1200. This can minimize the stop of the manufacturing line.

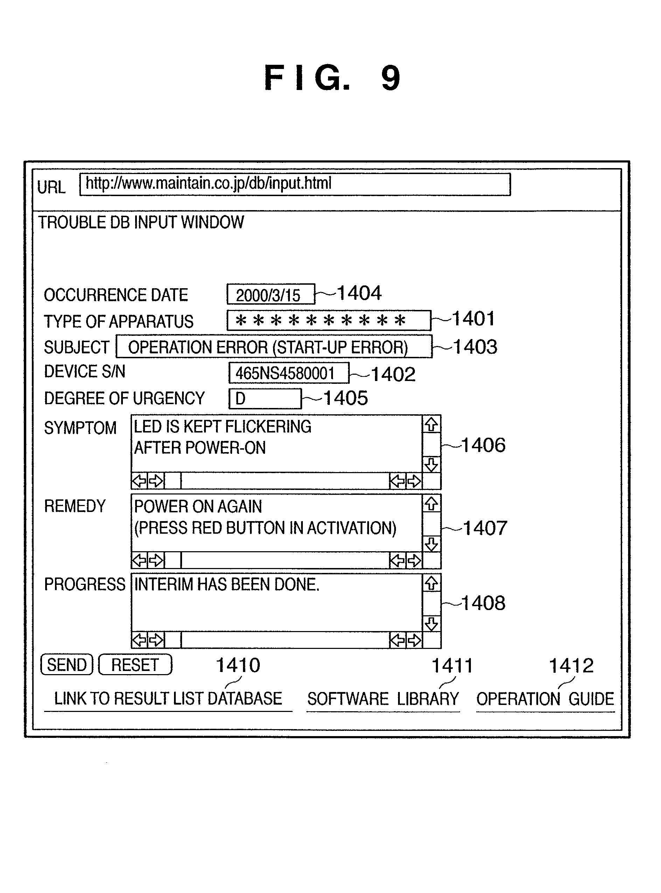

Each manufacturing apparatus in the semiconductor manufacturing factory comprises a display, a network interface, and a computer which executes network access software and apparatus operating software which are stored in a storage device. The storage device is a built-in memory, hard disk, or network file server. The network access software includes a dedicated or general-purpose web browser, and provides a user interface with a window as shown in Fig. 9 on the display. While referring to this window, the operator who manages manufacturing apparatuses in each factory inputs, into input fields on the windows, pieces of information such as the model of manufacturing apparatus 1401, serial number 1402, subject of trouble 1403, data of occurrence of trouble 1404, degree of urgency 1405, symptom 1406, remedy 1407, and progress 1408. The pieces of input information are transmitted to the maintenance database via the Internet, and appropriate maintenance information is sent back from the maintenance database and provided on the display. The user interface provided by the web browser realizes hyperlink functions 1410 to 1412, as shown in Fig. 9. This allows the operator to access more detailed information of each item, download the latest-version software to be used for a manufacturing apparatus from a software library provided by a vendor, and download an operation guide (help information) as a reference for the operator in the factory. The maintenance information provided from the maintenance database includes information about the present invention described above. The software library also provides the latest-version software for implementing the present invention.

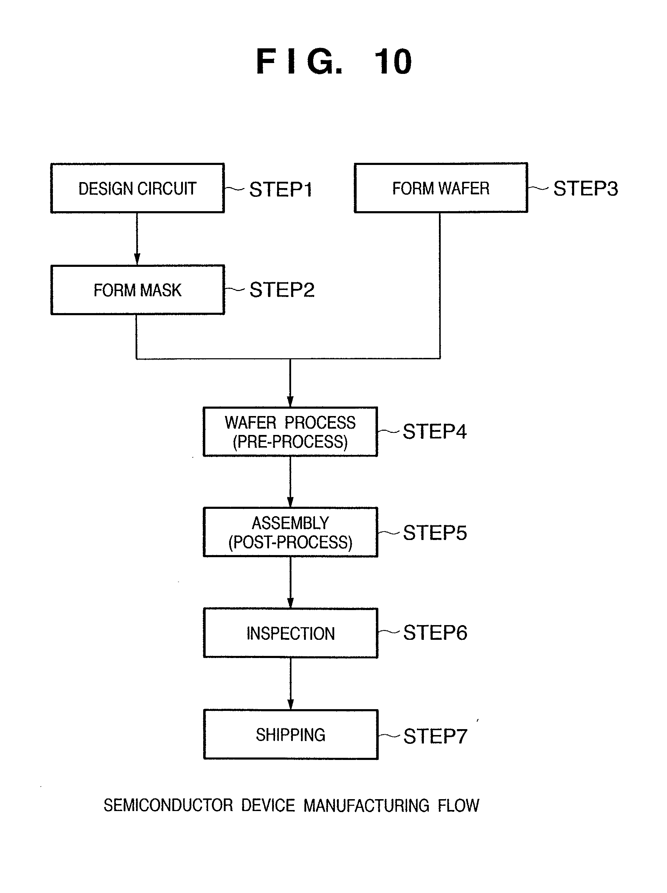

A semiconductor device manufacturing process using the above-described production system will be explained. Fig. 10 shows the flow of the whole manufacturing process of the semiconductor device. In step 1 (circuit design), a semiconductor device circuit is designed. In step 2 (mask formation), a mask having the designed circuit pattern is formed. In step 3 (wafer formation), a wafer is formed by using a material such as silicon. In step 4 (wafer process) called a pre-process, an actual circuit is formed on the wafer by lithography using the prepared mask and wafer. Step 5 (assembly) called a post-process is the step of forming a semiconductor chip by using the wafer formed in step 4, and includes an assembly process (dicing and bonding) and packaging process (chip encapsulation). In step 6 (inspection), the semiconductor device manufactured in step 5 undergoes inspections such as an operation confirmation test and durability test. After these steps, the semiconductor device is completed and shipped (step 7). For example, the pre-process and post-process are performed in separate dedicated factories, and each of the factories receives maintenance by the above-described remote maintenance system. Information for production management and apparatus maintenance is communicated between the pre-process factory and the post-process factory via the Internet or dedicated network.

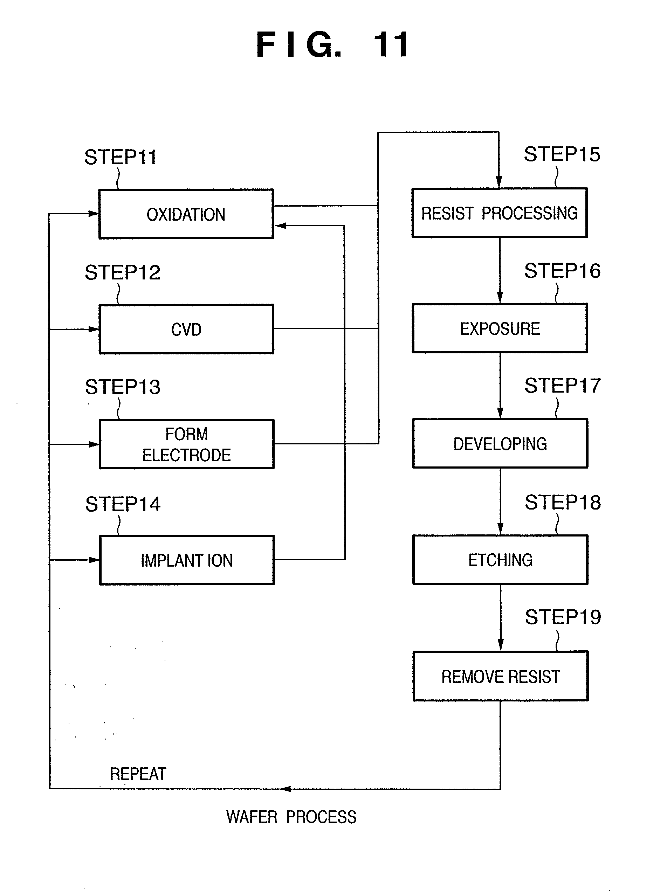

Fig. 11 shows the detailed flow of the wafer process. In step 11 (oxidation), the wafer surface is oxidized. In step 12 (CVD), an insulating film is formed on the wafer surface. In step 13 (electrode formation), an electrode is formed on the wafer by vapor deposition. In step 14 (ion implantation), ions are implanted in the wafer. In step 15 (resist processing), a photosensitive agent is applied to the wafer. In step 16 (exposure), the above-mentioned exposure apparatus exposes the wafer to the circuit pattern of a mask, and prints the circuit pattern on the wafer. In step 17 (developing), the exposed wafer is developed. In step 18 (etching), the resist is etched except for the developed resist image. In step 19 (resist removal), an unnecessary resist after etching is removed. These steps are repeated to form multiple circuit patterns on the wafer. A manufacturing apparatus used in each step undergoes maintenance by the remote maintenance system, which prevents a trouble in advance. Even if a trouble occurs, the manufacturing apparatus can be quickly recovered. The productivity of the semiconductor device can be increased in comparison with the prior art.

According to the preferred embodiment of the present invention, since the temperature of the substrate such as the wafer loaded into the process chamber of the apparatus via the load-lock chamber reaches the predetermined temperature at the time of loading, the substrate can be immediately processed, e.g., subjected to exposure, thereby improving the throughput. In particular, the larger effect can be attained in the apparatus with the evacuated chamber.

As many apparently widely different embodiments of the present invention can be made without departing from the spirit and scope thereof, it is to be understood that the invention is not limited to the specific embodiments thereof except as defined in the appended claims.

## Claims

1. A substrate processing apparatus comprising:
a first chamber;
a second chamber which has first and second valves, and communicates with said first chamber via the second valve, wherein a substrate transferred to said second chamber is transferred to said first chamber through the second valve; and
a thermoregulator which regulates a temperature of the substrate to be transferred to said second chamber through the first valve before transferring to said second chamber.

2. The apparatus according to claim 1, wherein said thermoregulator is arranged to heat the substrate.

3. The apparatus according to claim 1, further comprising a pressure reduction mechanism which reduces a pressure in said second chamber before transferring the substrate from said second chamber to said first chamber after transferring the substrate to said second chamber.

4. The apparatus according to claim 3, further comprising a gas supply mechanism which supplies predetermined gas into said second chamber to match an environment in said second chamber to an environment in said first chamber before transferring the substrate from said second chamber to said first chamber after the pressure reduction mechanism reduces the pressure in said second chamber.

5. The apparatus according to claim 3, wherein the substrate temperature in said second chamber is reduced with a decrease in pressure in said second chamber, and
thermoregulation of the substrate by the thermoregulator is determined in consideration of the reduction of the substrate temperature in said second chamber so as to transfer the substrate with a predetermined temperature from said second chamber to said first chamber.

6. The apparatus according to claim 3, wherein thermoregulation of the substrate by the thermoregulator is carried in consideration of the reduction of the substrate temperature in said second chamber and change in the substrate temperature during period from transferring the substrate to said first chamber until processing the substrate.

7. The apparatus according to claim 1, wherein the thermoregulator is arranged to regulate the substrate temperature in a state wherein the substrate is held by a substrate transfer mechanism for transferring the substrate to said second chamber.

8. The apparatus according to claim 1, wherein the thermoregulator is arranged to regulate the substrate temperature by supplying gas to the substrate.

9. The apparatus according to claim 7, wherein the thermoregulator has a removing portion for removing particles from gas to be supplied to the substrate.

10. The apparatus according to claim 1, further comprising a temperature measuring device which measures the substrate temperature regulated by the thermoregulator to supply the measurement result to the thermoregulator.

11. The apparatus according to claim 1, wherein an exposure process portion for transferring a pattern onto the substrate is arranged in said first chamber.

12. The apparatus according to claim 11, wherein the atmosphere in said first chamber is maintained to a reduced pressure.

13. A substrate processing method comprising the steps of:
heating a substrate;
supplying the heated substrate to a load-lock chamber;
reducing a pressure in the load-lock chamber;
supplying the substrate from the load-lock chamber to a process chamber; and
processing the substrate in the process chamber.

14. The method according to claim 13, further comprising the step of supplying predetermined gas into the load-lock chamber to match an environment in the load-lock chamber to an environment in the process chamber before transferring the substrate from the load-lock chamber to the process chamber after reducing the pressure in the load-lock chamber.

15. A device manufacturing method comprising the steps of:
installing, in a device manufacturing factory, manufacturing apparatuses for various processes including the substrate processing apparatus defined in claim 1; and
manufacturing a device by a plurality of processes using the manufacturing apparatuses.

16. The method according to claim 15, further comprising the steps of:
connecting the manufacturing apparatuses via a local area network; and
communicating information about at least one of the manufacturing apparatuses between the local area network and an external network outside the device manufacturing factory.

17. The method according to claim 16, further comprising the step of accessing a database provided by a vendor or user of the substrate processing apparatus via the external network, thereby obtaining maintenance information of the exposure apparatus by data communication.

18. The method according to claim 16, further comprising the step of performing data communication between the device manufacturing factory and another device manufacturing factory via the external network, thereby performing production management.

19. A device manufacturing factory comprising:
manufacturing apparatuses for various processes including the substrate processing apparatus defined in claim 1;
a local area network for connecting the manufacturing apparatuses; and
a gateway for allowing access to an external network outside the factory from the local area network,
wherein information about at least one of the manufacturing apparatuses is communicated between said local area network and the external network.

20. A maintenance method for the substrate processing apparatus defined in claim 1 that is installed in a device manufacturing factory, comprising the steps of:
making a vendor or user of the substrate processing apparatus provide a maintenance database connected to an external network outside the device manufacturing factory;
allowing access to the maintenance database from the device manufacturing factory via the external network; and
transmitting maintenance information accumulated in the maintenance database to the device manufacturing factory via the external network.

21. The apparatus according to claim 1, wherein
the apparatus further comprises:
a display;
a network interface; and
a computer for executing network software, and
said display, said network interface, and said computer enable communicating maintenance information of the substrate processing apparatus via a computer network.

22. The apparatus according to claim 21, wherein the network software provides on said display said user interface for accessing a maintenance database provided by a vendor or user of the substrate processing apparatus and connected to the external network outside a factory in which the substrate processing apparatus is installed, and information is obtained from the database via the external network.
